(19) Europäisches Patentamt
European Patent Office
Office européen des brevets

(11) **EP 4 333 228 A1**

(12) **EUROPEAN PATENT APPLICATION**

(43) Date of publication:
**06.03.2024 Bulletin 2024/10**

(51) International Patent Classification (IPC):
***H02H 1/04*** *(2006.01)* ***G01R 31/08*** *(2020.01)*
***H02H 3/00*** *(2006.01)* ***H02H 3/28*** *(2006.01)*

(21) Application number: **22192822.9**

(22) Date of filing: **30.08.2022**

(52) Cooperative Patent Classification (CPC):
**H02H 3/28; H02H 1/04; H02H 3/006; G01R 31/085**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Hitachi Energy Ltd
8050 Zürich (CH)**

(72) Inventors:
• WANG, Jianping
  72460 Västerås (SE)
• LI, YouYi
  72219 Västerås (SE)
• HOHN, Fabian
  72226 Västerås (SE)

(74) Representative: **Vossius & Partner
Patentanwälte Rechtsanwälte mbB
Siebertstraße 3
81675 München (DE)**

(54) **ADAPTIVE FAULT DISCRIMINATION FOR A LINE DIFFERENTIAL PROTECTION**

(57) The present disclosure relates to a method for controlling a line differential protection system for an electrical power system. The method comprises sensing at least one first parameter at a first end of a transmission line of the electrical power system; determining, based on the sensed at least one first parameter, an abnormal operation condition; adjusting, based on the determined abnormal operation condition, a preset setting of the line differential protection system; and controlling, based on the adjusted preset setting, the line differential protection system. The present disclosure also relates to a respective device and system.

S101 — sensing at least one first parameter at a first end of a transmission line of the electrical power system

S102 — determining, based on the sensed at least one first parameter, an abnormal operation condition

S103 — adjusting, based on the determined abnormal operation condition, a preset setting of the line differential protection system

S104 — controlling, based on the adjusted preset setting, the line differential protection system

FIG. 1

EP 4 333 228 A1

**Description**

The present disclosure relates to a method, a device, and an electrical power system for controlling a line differential protection system for a transmission line with a shunt reactor, the system comprising a first differential protection device located at a first end of a line segment of an electrical power transmission line and a second differential protection device located at a second end of the line segment of the electrical power transmission line.

A line differential protection is widely used as a transmission protection system in many applications, including a windfarm application comprising a long transmission line. Conventionally, a line differential protection trips a corresponding device, e.g. a relay, to prevent further propagation of the fault when an internal fault occurs. In contrary, when an external fault occurs or during normal operation conditions such as switching in and switching off the lines, the line differential protection does not trip the corresponding device. Thus, it is important to discriminate, or equivalently determine, the fault accurately and reliably.

A challenge is posed when the switching operation causes observing quantities to resemble the dynamic behaviours thereof observed during the internal fault. In such case, a conventional line differential protection determines the fault to be an internal fault and trips the corresponding relay, which in turn causes a maloperation. Thus, there is a need to improve a method, a device, and an electrical power system of the fault discrimination for a line differential protection.

The present disclosure relates to a method for controlling a line differential protection system for an electrical power system, the method comprising: sensing at least one first parameter at a first end of a transmission line of the electrical power system; determining, based on the sensed at least one first parameter, an abnormal operation condition; adjusting, based on the determined abnormal operation condition, a preset setting of the line differential protection system; and controlling, based on the adjusted preset setting, the line differential protection system.

According to an embodiment, a segment of the transmission line between the first end and the second end is protected by the line differential protection system.

According to an embodiment, the at least one first parameter is at least one of individual phase (e.g. phase-A, phase-B, phase-C, and so forth) current through the first end of the transmission line. According to an embodiment, the at least one first parameter is a voltage sensed at the first end of the transmission line.

According to an embodiment an abnormal condition is or comprises any operating condition deviating from a normal operating condition, in particular caused by a phenomenon different from a fault, more particularly a short-circuit fault or an electrical-grounding fault. According to an embodiment, an abnormal operating condition is or comprises an operating condition caused by an open circuit of the transmission line or at least one of phases carried on the transmission line, in particular the open circuit occurs outside of a protected portion of the transmission line, more particularly the open circuit is caused by a switching component.

According to an embodiment, the line differential protection system remains stable, inaction, held off, or any of the equivalent action, in particular when the abnormal operation is detected, more particularly when the operating condition is determined to be caused by the open circuit of the transmission line or at least one of phases carried on the transmission line. According to an embodiment, the line differential protection system is triggered when the abnormal operation is detected.

According to an embodiment, the abnormal operation condition comprises any form of deviation from a normal operation in parameters, in particular the sensed parameters, related to the transmission line to be protected. According to an embodiment, the abnormal operating condition is an indicator that there is no fault within and/or outside of the protected portion of the transmission line. According to an embodiment, a fault is determined when the parameters, in particular the sensed parameters, related to the transmission line satisfy a criterion (e.g. the parameters are higher than thresholds, meets a boundary condition, or the like).

According to an embodiment, the method further comprises: determining, based on the adjusted preset setting, a fault in the transmission line; and controlling, based on the determined fault, the line differential protection system. According to an embodiment, the controlling the line differential protection system comprises controlling an operation of the line differential protection system.

According to an embodiment, the method further comprises: sensing at least one second parameter at a second end of the transmission line, wherein the sensed at least one first parameter is or comprises a single-phase current through the first end and the sensed at least one second parameter is or comprises a single-phase current through the second end; determining, based on the sensed at least one first parameter and the sensed at least one second parameter, a differential current; sensing a current through a shunt component connected to the transmission line, in particular at the first end of the transmission line; and determining, based on the determined differential current and the sensed current through the shunt component, the abnormal operation condition.

According to an embodiment, the electrical power system comprises the shunt component electrically coupled to the transmission line, in particular at a first end of the transmission line. According to an embodiment, the shunt component is a shunt reactor.

According to an embodiment, the at least one second parameter is at least one of individual phase (e.g. phase-A, phase-B, phase-C, and so forth) current through the second end of the transmission line.

According to an embodiment, the abnormal operation condition is determined when the determined differential current and the sensed current through the shunt component increase simultaneously.

According to an embodiment, the sensed at least one first parameter is a voltage at the first end and wherein the determining the abnormal operation condition is or comprises comparing the sensed at least one first parameter to a preset value.

According to an embodiment, the sensed at least one first parameter is or comprises a single-phase current through the first end and wherein the determining the abnormal operation condition is or comprises comparing the sensed at least one first parameter to a preset value.

According to an embodiment, the adjusting the preset setting is or comprises increasing a threshold value of the preset setting of the line differential protection system.

According to an embodiment, the method further comprises determining, based on the adjusted preset setting, an internal fault.

According to an embodiment, the internal fault occurs within the first end and the second end of the electrical power transmission line and the external fault occurs outside of the first end and the second end of the electrical power transmission line.

According to an embodiment, the method further comprises controlling, based on the determined internal fault, the line differential protection system, in particular by opening a circuit breaker of the differential protection system, more particularly the circuit breaker located at a respective ends of the transmission line.

According to an embodiment, the determining the differential current, the rate of change of the differential current, and/or the rate of change of the current through the shunt reactor comprises determining root-mean-square values and/or performing discrete Fourier transformation.

According to an embodiment, the increasing the threshold value comprises increasing the threshold value when the rate of change of both the differential current and the current through the shunt reactor are positive.

According to an embodiment. the rate of change of the differential current is higher than the first set value and the rate of change of the current through the shunt reactor is higher than the second set value.

The present disclosure also relates to a device for controlling a line differential protection system for an electrical power system, the device comprising a processor being configured to: determine, based on at least one first parameter, an abnormal operation condition; adjust, based on the determined abnormal operation condition, a preset setting of the line differential protection system; and control, based on the adjusted preset setting, the line differential protection system.

According to an embodiment, the processor is further configured to: determine, based on the adjusted preset setting, a fault in the transmission line; and controlling, based on the determined fault, the line differential protection system. According to an embodiment, the controlling the line differential protection system comprises controlling an operation of the line differential protection system.

According to an embodiment, the device further comprises a first sensor configured to sense the at least one first parameter at a first end of a transmission line of the electrical power system, wherein the sensed at least one first parameter particularly comprises a single-phase current through the first end.

According to an embodiment, the device further comprises a second sensor configured to sense at least one second parameter at a second end of the transmission line, wherein the sensed at least one second parameter is or comprises a single-phase current through the second end, wherein the sensed at least one first parameter comprises a current through a shunt component connected to the transmission line, in particular at the first end of the transmission line; and; and wherein the processor is further configured to: determine, based on the sensed at least one first parameter and the sensed at least one second parameter, a differential current; and determine, based on the determined differential current and the sensed current through the shunt component, the abnormal operation condition.

According to an embodiment, the first sensor and the second sensor are communicatively coupled to each other and/or to the processor.

According to an embodiment, the line differential protection system comprises controlled actuatable devices, including a relay, a current transformer, a voltage transformer, and/or a trip circuit, and/or circuit breakers located at respective ends (the first end and the second end) of the transmission line and/or the protected portion of the transmission line. According to an embodiment, the controlling the line differential protection system comprises controlling any combination of the controlled actuatable devices.

According to an embodiment, the processor is configured to determine the abnormal operation condition when the determined differential current and the sensed current through the shunt component increase simultaneously.

According to an embodiment, the sensed at least one first parameter is a voltage at the first end and wherein the processor is configured to determine the abnormal operation condition by comparing the sensed at least one first parameter to a preset value.

According to an embodiment, the sensed at least one first parameter is or comprises a single-phase current through the first end and wherein the processor is configured to determine the abnormal operation condition by comparing the sensed at least one first parameter to a preset value.

According to an embodiment, the processor is configured to adjust the preset setting by increasing a threshold value of the preset setting of the line differential protection system.

The present disclosure further relates to an electrical power system comprising a transmission line and the device according to any one of the above-described embodiments.

The following items refer to particular embodiments of the present disclosure:

1. A method for controlling a line differential protection system for a transmission line with a shunt reactor, the system comprising a first differential protection device located at a first end of a line segment of an electrical power transmission line and a second differential protection device located at a second end of the line segment of the electrical power transmission line, the method comprising:

measuring, using the first differential protection device and/or the second differential protection device, a first voltage at the first end and/or a second voltage at the second end;
comparing the measured first voltage to a first set value and/or the measured second voltage to a second set value; and
adjusting, based on the comparing, a threshold value.

2. The method of item 1, further comprising determining, based on the adjusted threshold value, by the first line differential protection device and/or the second line differential protection device, an internal fault.

3. The method of item 2, wherein the internal fault occurs within the first end and the second end of the electrical power transmission line and the external fault occurs outside of the first end and the second end of the electrical power transmission line.

4. The method of item 2 or 3, further comprising controlling, based on the determined internal fault, the first differential protection device and/or the second differential protection device.

5. The method of any one of items 1 to 4, wherein the adjusting the threshold value comprises increasing the threshold value when the measured first voltage is higher than the first set value and/or the measured second voltage is higher than the second set value.

Various exemplary embodiments of the present disclosure disclosed herein are directed to providing features that will become readily apparent by reference to the following description when taken in conjunction with the accompanying drawings. In accordance with various embodiments, exemplary systems, methods, and devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The above and other aspects and their implementations are described in greater detail in the drawings, the descriptions, and the claims.

**Description of the Drawings**

FIG. 1 illustrates a flow chart of the method according to an embodiment of the present disclosure.

FIG. 2 illustrates a system overview of the considered electrical power system according to an embodiment of the present disclosure.

FIG. 3 illustrates an exemplary combination of exemplary criteria used in preset setting adjustment of the method according to an embodiment of the present disclosure.

FIG. 4 illustrates three-phase measurements obtained during an external fault according to an embodiment of the present disclosure.

FIG. 5 illustrates amplitudes of the measured three-phase currents according to an embodiment of the present disclosure.

FIG. 6 illustrates an operational characteristics of a conventional line differential protection.

FIG. 7a) and FIG. 7b) illustrate measurements during different operation conditions according to an embodiment of the present disclosure.

FIG. 8a) to FIG. 8d) illustrate measurement results at various measurement points along the transmission line illustrated in FIG. 1.

FIG. 9 illustrates a flow chart of the method according to an embodiment of the present disclosure.

FIG. 10a) and FIG. 10b) illustrate measurements and computed parameters of a single phase signal during different operation conditions.

FIG. 11a) and FIG. 11b) illustrate a device and an electrical power system according to embodiments of the present disclosure.

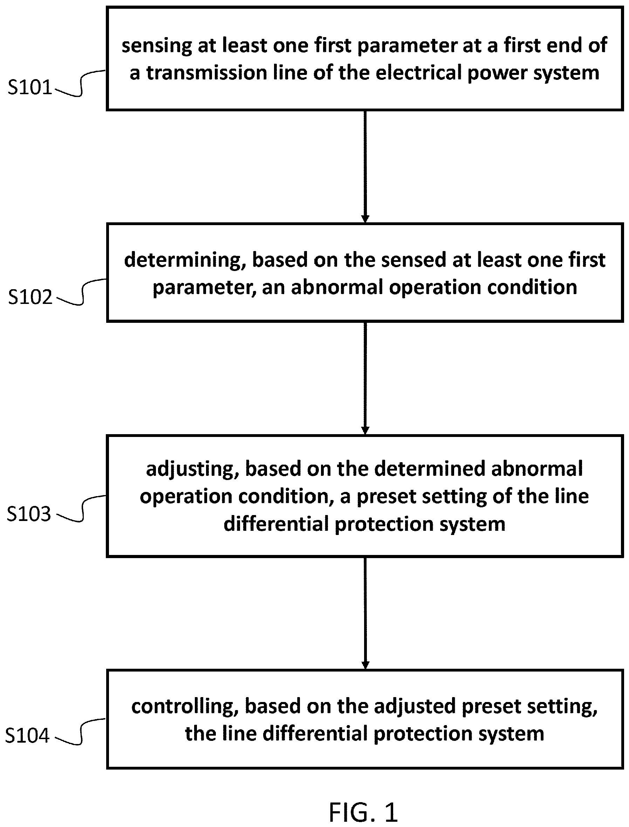

FIG. 1 illustrates a flow chart of the method according to an embodiment of the present disclosure. A first block S101 performs the sensing at least one first parameter at a first end of a transmission line of the electrical power system. A second block S102 performs the determining, based on the sensed at least one first parameter, an abnormal operation condition. A third block S103 performs the adjusting, based on the determined abnormal operation condition, a preset setting of the line differential protection system. A fourth block S104 performs the controlling, based on the adjusted preset setting, the line differential protection system.

According to an embodiment an abnormal condition is or comprises any operating condition deviating from a normal operating condition, in particular caused by a phenomenon different from a fault, more particularly a short-circuit fault or an electrical-grounding fault. According to an embodiment, an abnormal operating condition is or comprises an operating condition caused by an open circuit of the transmission line or at least one of phases carried on the transmission line, in particular the open circuit is caused by a switching element, more particularly the open circuit occurs outside of a protected portion of the transmission line.

According to an embodiment, the line differential protection system remains stable, inaction, held off, or any of the equivalent action, in particular when the abnormal operation is detected, more particularly when the operating condition is determined to be caused by the open circuit of the transmission line or at least one of phases carried on the transmission line. According to an embodiment, the line differential protection system is triggered when the abnormal operation is detected.

According to an embodiment, the at least one first parameter is received. It is understood by the skilled person that the wording 'sending' may hold the same meaning, thusly may be used interchangeably with, 'obtaining', 'measuring', or the like. Similarly, the wording 'determining' may be used interchangeably with, 'detecting', 'establishing', or the like.

According to an embodiment, a segment of the transmission line between the first end and the second end is protected by the line differential protection system.

According to an embodiment, the at least one first parameter is at least one of individual phase (e.g. phase-A, phase-B, phase-C, and so forth) current through the first end of the transmission line. According to an embodiment, the at least one first parameter is a voltage sensed at the first end of the transmission line.

According to an embodiment, the abnormal operation condition comprises any form of deviation from a normal operation in parameters, in particular the sensed parameters, related to the transmission line to be protected. According to an embodiment, the abnormal operating condition is an indicator that there is no fault within and/or outside of the protected portion of the transmission line. According to an embodiment, a fault is determined when the parameters, in particular the sensed parameters, related to the transmission line satisfy a criterion (e.g. the parameters are higher than thresholds, meets a boundary condition, or the like).

According to an embodiment, the method further comprises: determining, based on the adjusted preset setting, a fault in the transmission line; and controlling, based on the determined fault, the line differential protection system.

According to an embodiment, the controlling the line differential protection system comprises controlling an operation of the line differential protection system.

According to an embodiment, the method further comprises: sensing at least one second parameter at a second end of the transmission line, wherein the sensed at least one first parameter is or comprises a single-phase current through the first end and the sensed at least one second parameter is or comprises a single-phase current through the second end; determining, based on the sensed at least one first parameter and the sensed at least one second parameter, a differential current; sensing a current through a shunt component connected to the transmission line, in particular at the first end of the transmission line; and determining, based on the determined differential current and the sensed current through the shunt component, the abnormal operation condition.

According to an embodiment, the electrical power system comprises the shunt component electrically coupled to the transmission line, in particular at a first end of the transmission line. According to an embodiment, the shunt component is a shunt reactor.

According to an embodiment, the at least one second parameter is at least one of individual phase (e.g. phase-A, phase-B, phase-C, and so forth) current through the second end of the transmission line.

According to an embodiment, the abnormal operation condition is determined when the determined differential current and the sensed current through the shunt component increase simultaneously.

According to an embodiment, the sensed at least one first parameter is a voltage at the first end and wherein the determining the abnormal operation condition is or comprises comparing the sensed at least one first parameter to a preset value.

According to an embodiment, the sensed at least one first parameter is or comprises a single-phase current through the first end and wherein the determining the abnormal operation condition is or comprises comparing the sensed at least one first parameter to a preset value.

According to an embodiment, the adjusting the preset setting is or comprises increasing a threshold value of the preset setting of the line differential protection system.

According to an embodiment, the method further comprises determining, based on the adjusted preset setting, an internal fault or an external fault.

According to an embodiment, the internal fault occurs within the first end and the second end of the electrical power transmission line and the external fault occurs outside of the first end and the second end of the electrical power transmission line.

According to an embodiment, the method further comprises controlling, based on the determined internal fault, the line differential protection system, in particular by opening a circuit breaker of the differential protection system, more particularly the circuit breaker located at a respective end of the transmission line.

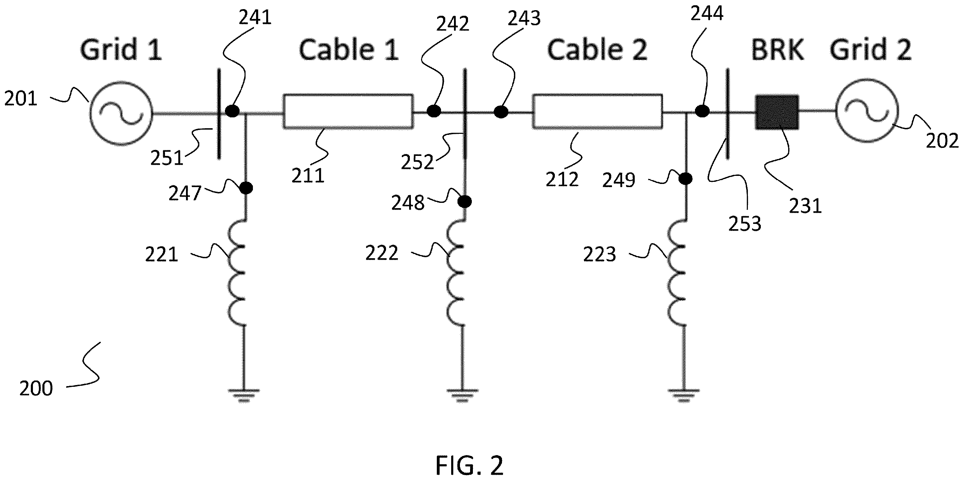

FIG. 2 illustrates a system overview of the considered electrical power system according to an embodiment of the present disclosure. In particular, the illustrated system considers an offshore windfarm application, wherein a wind turbine generator 201 is connected to a grid source 202 via a long cable. The long cable is represented by electrical equivalent components of segments including a first cable segment 211 and a second cable segment 212 and buses 251, 252, and 253. In this exemplary embodiment, = the second cable segment 212 is to be protected. The second cable segment 212 may be an electrical model, in particular an impedance, of the transmission line between measurement points 243 and 244, or between buses 252 and 253. A fault occurring within the second cable segment 212 is defined as an internal fault, in particular within the second cable segment 212. The first cable 211 is also to be protected. The first cable segment 211 may be an electrical mode, in particular an impedance, of the transmission line between measurement points 241 and 242, or between buses 251 and 252. A fault occurring within the first cable segment 211 is defined as an internal fault, in particular within the first cable segment 211. According to an embodiment, a fault occurring within the first segment 211 and/or the second segment 212 are defined as an internal fault, in particular the internal fault of the transmission line. According to an embodiment, all segments of the long cable are to be protected and thusly a fault occurring within at least one of the cable segments (cable 211 or cable 212), also referred to as the protected segments, is defined as an internal fault for the corresponding line differential protection systems. It is understood by the skilled person that the above mentioned protected segments may not be limiting to two segments and the transmission line may further comprise further protected segments. It is understood by the skilled person that the first cable segment 211 can be modeled as an ideal transmission line with a first leakage capacitor connecting the first cable segment 211 of the transmission line to the electrical ground and similarly, the second cable segment 212 can be modeled as an ideal transmission line with a second leakage capacitor connecting the second cable segment 212 of the transmission line to the electrical ground. According to an embodiment, the first and the leakage capacitors are shunt capacitors. The system 200 further comprises inductive components 221, 222, and 223 which electrically connect various points of the long cable to the electrical ground. The system further comprises a circuit breaker 231 to electrically connect or disconnect the grid source 202 from the long cable. Various measurement points 241, 242, 243, and 244 along the long cable line are indicated with block dots. Further measurement points 247, 248, and 249 are indicated with black dots and measure the current through the inductive components 221, 222, and 223, respectively. It is understood by the skilled person that the inductive components 221, 222, and 223 may be shunt reactors which may be used to stabilize the voltage across long cable over different load conditions. The shunt reactor may be used to compensated capacitive leakage currents, so as to keep the voltage along the transmission line to be in the reasonable ranges to avoid possible overvoltage during energization of long cable line. The location of shunt reactors is normally dependent on the control convenience and service easiness for utility personals. A first current, $I_{4grid}$, is a sum of the current, measured at a fourth measurement point 244, through the third inductive component 223 measured at point 249 and the current entering cable 2 from the grid side 202. A second current, 13, enters the second cable segment 212 from the first cable segment 211 and is observed at a third measurement point 243. According to an embodiment, the second current is a sum of the current measured at a second measurement point 242 and the current through the second inductive component 222 measured at 248. According to an embodiment, the fourth measurement point 244 is the first end of the long cable and the at least one first parameter is or comprises the first current $I_{4grid}$. According to an embodiment, the third measurement point 243 is the second end of the long cable and the at least one second parameter is or comprises the second current 13. According to an embodiment, the first measurement point 241 is the second end of the long cable and the at least one second parameter is or comprises the current through the first measurement point 241.

A differential current $I_{diff}$ and a restrain current $I_{res}$ are computed based on I3 and $I_{4grid}$ as follows:

$$I_{res} = |I_3| + |I_{4grid}| \qquad (1)$$

$$I_{diff} = |I_3 + I_{4grid}| \qquad (2)$$

Conventionally, a line differential protection discriminates, or equivalently determines, a fault by subtracting weighted $I_{res}$ from $I_{diff}$ and compare to a threshold value as follows:

$$I_{diff} - \alpha \times I_{res} > I_{th} \qquad (3)$$

, wherein $I_{th}$ and $\alpha$ denote a threshold current and a restrained coefficient, respectively. $I_{th}$ may be different for different cable segments of the transmission line. When the criterion of eq.(3) is satisfied, the conventional line differential protection determines the fault to be an internal fault and controls the line differential protection system, e.g. trips an associated circuit breaker through the differential protection relay..

When a non-internal fault occurs, in particular when the circuit breaker 231 opens, i.e. the long cable is electrically disconnected from the grid source 202, the differential current $I_{diff}$ and/or the restrain current $I_{res}$ vary in a similar manner as an internal fault. In particular, for the long cable connected line, once the circuit breaker 231 is closed, i.e. the long cable is electrically connected to the grid 202, the line inductive current is equal to zero. On the other hand, when the circuit breaker 231 opens, the initial electro-magnetic field energy stored in the line is transferred to an electric field as a capacitor current, so that the total line capacitor current along the line may be increased. Consequently, the line voltage at the fourth measurement point 244 increases, e.g.) by a factor of 2, such phenomenon is herein referred to as an overvoltage. The overvoltage may be dampened over time, i.e. the magnitude decreases over time, and the overvoltage may occur at various measurement points 241, 242, 243, and/or 244. As a result, the current through the leakage capacitor of the second line segment 212, herein referred to as a second capacitive leakage current, increases and simultaneously the current through the third inductive component 223, herein referred to as a third shunt reactor current, increases due to the said overvoltage. The current through various measurement points 241, 242, 243, and/or 244 may also increase as a result of the overvoltage. The differential currents measured both for cable segments 211 and 212 increase. In such case, the increase of second capacitive leakage current yields the differential current $I_{diff}$ and/or the restrain current $I_{res}$ to vary from a normal operation, i.e. in the absence of faults, in a similar manner as said currents would vary in an internal fault. Consequently, a conventional line differential protection may determine, by evaluating the criterion of eq.(3), the fault to be an internal fault and accordingly issue a tripping of the associated circuit breakers. Thus, it is proposed to evaluate at least one criterion other than the criterion of eq.(3) and adjust the threshold current of eq.(3) accordingly. For simplicity, the capacitive components coupling the long cable to the ground potential are omitted. The capacitive leakage current is conducted through the omitted capacitive components. That is, the capacitive leakage current along the cable line may be distributed along the whole cable line through distributed line to ground capacitances which are not shown here in figure 2.

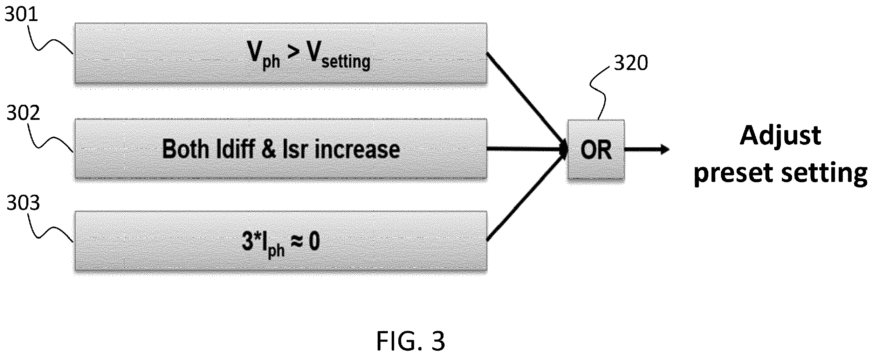

FIG. 3 illustrates an exemplary combination of exemplary criteria used in preset setting adjustment of the method according to an embodiment of the present disclosure. The method evaluates a first criterion 301, a second criterion 302, and a third criterion 303. The results of the three criteria 301 to 303 are combined using an 'OR' operator 320 to adjust a preset setting.

The first criterion 301 evaluates the following voltage condition:

$$V_{ph} > V_{setting} \qquad\qquad (4)$$

, wherein $V_{ph}$ and $V_{setting}$ denote the voltage measurements at the fourth measurement point 244 and a voltage setting, respectively. That is, the first criterion 301 monitors the fourth measurement point 244 to detect any overvoltage. According to an embodiment, the overvoltage is caused by the opening of the circuit breaker 231. According to an embodiment, the overvoltage is caused by an electrical disturbance different from the opening of the circuit breaker 231.

The second criterion 302 evaluates the rate of changes of the $I_{diff}$ and the third shunt reactor current $I_{sr}$ through the third inductive component 223. In particular, the second criterion 302 evaluates the simultaneous increase in $I_{diff}$ and $I_{sr}$. According to an embodiment, a stream of data is evaluated with a moving window to determine the simultaneous increase. According to an embodiment, the following conditions are evaluated:

$$\frac{dI_{diff}(t)}{dt} > 0 \qquad\qquad (5)$$

$$\frac{dI_{sr}(t)}{dt} > 0 \qquad\qquad (6)$$

. That is, the second criterion 302 monitors the overvoltage or a large charging current (e.g. I_charge > 1500 A). According to an embodiment, the overvoltage and/or the large charging current is caused by the opening of the circuit breaker 231. According to an embodiment, the overvoltage and/or the large charging current is caused by an electrical disturbance different from the opening of the circuit breaker 231.

The third criterion 303 evaluates the following condition:

$$\alpha_{ph} \times I_{ph} \approx 0 \qquad\qquad (7)$$

, wherein $\alpha_{ph}$ denotes a multiplication constant (e.g. $\alpha_{ph}$ = 3) and $I_{ph}$ denotes the second at least one current, $I_{4grid}$. That is, the third criterion 303 monitors an electrical disconnection at the node to which the grid source 202 side is connected. According to an embodiment, the electrical disconnection is caused by the opening of the circuit breaker 231. According to an embodiment, the electrical disconnection is caused by an electrical disturbance different from the opening of the circuit breaker 231.

It is understood by the skilled person that once any one of the criteria 301, 302, and 303 is satisfied, an abnormal operation condition is determined. The method adjusts, based on the results of said criteria 301 to 303 and using the 'OR' operator 320, the preset setting. According to an embodiment, the adjusting the preset setting comprises adjusting values of the multiplication constant $\alpha$ and/or the threshold current $I_{th}$ of eq.(3). According to an embodiment, the adjusting the preset setting may be based on any one of the said criteria or any combination of the said and/or any other criteria, in particular using at least one of 'AND' and/or 'OR' operators. According to another embodiment, the said criteria are evaluated in sequence and/or in parallel, so as to form any possible combination of an algorithmic hierarchy.

According to an embodiment, at least one of currents through the at least one inductive component, in particular a shunt reactor, is used in at least one of the criteria 301, 302, or 303 for adjusting the preset setting.

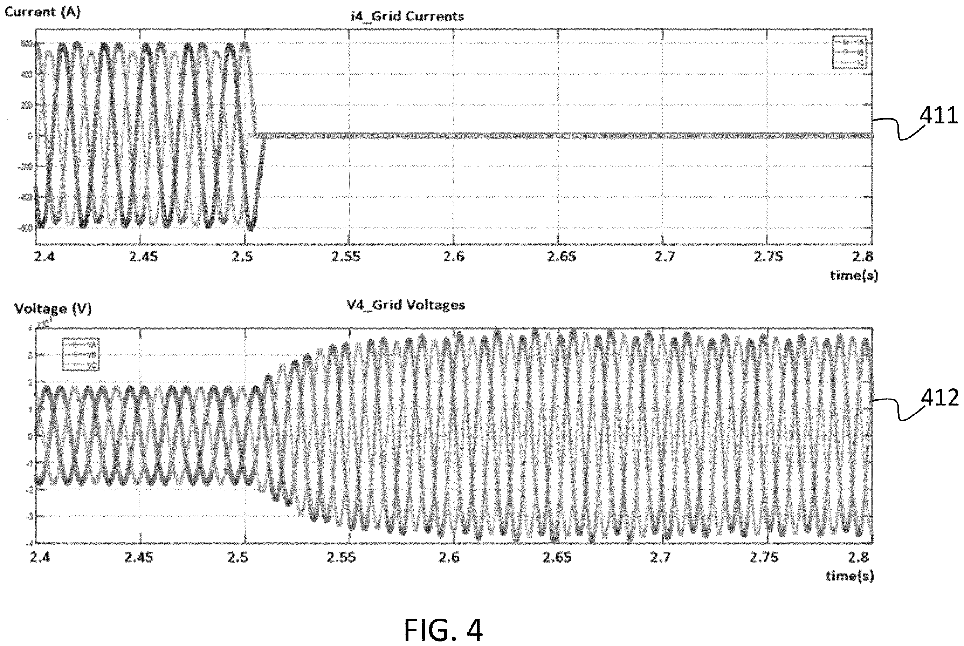

FIG. 4 illustrates three-phase measurements obtained during the normal load condition (t<2.5 seconds) period and opening of the circuit breaker 231 (t>=2.5 seconds) period according to an embodiment of the present disclosure. In particular, a first subplot 411 is a plot of 3-phase current measurement over time obtained at the fourth measurement point 244. A second subplot 412 is a plot of 3-phase voltage measurement over time obtained at a fourth measurement point 244. More particularly, the measurements in said subplots 411 and 412 are obtained within a time window, during which the circuit breaker 231 is opened, i.e. the long cable is electrically disconnected from the grid 202 at t= 2.5 *s*. When the circuit breaker 231 opens at t= 2.5 *s,* the overvoltage is observed for all monitored 3-phases at the fourth measurement point 244. Consequently, the amplitude of the current at the fourth measurement point 244 converges approximately to zero, as illustrated in the first subplot 411.

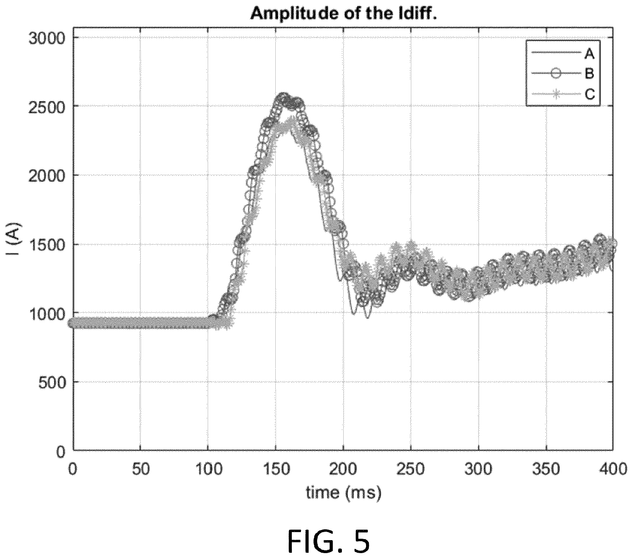

FIG. 5 illustrates amplitudes of the measured differential currents in each phase during normal load condition and during opening of circuit breaker 231 period according to an embodiment of the present disclosure. In particular, FIG. 5 illustrates the amplitudes of the differential currents for individual phases A, B, and C. The said differential currents are computed based on the measurements obtained within a time window, during which the circuit breaker 231 is opened, i.e. the long cable is electrically disconnected from the grid 202, at *t=100 ms.* It can be noticed that before the opening of circuit breaker 231 (t<100 ms), the differential currents in each phase are below 1000 A and the measured differential currents in each phase increase more than 2500 A after the opening of circuit breaker 231 (t>100ms).

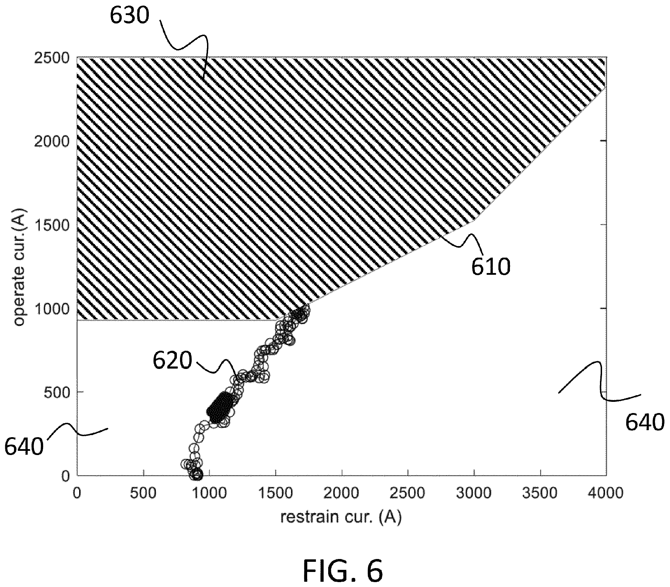

FIG. 6 illustrates an operational characteristics of a conventional line differential protection. The y-axis of the figure is an operating current, $I_{OP}$ (t), and denotes a time varying differential current subtracted by the pre-fault differential current $I_{diff,pre-fault}$ computed as follows:

$$I_{OP}(t) = I_{diff}(t) - I_{diff,pre-fault} \qquad (8)$$

, and the x-axis of the figure is the $I_{res}$. The boundary 610 splitting the current plane into an operation region 630 and a non-operation region 640, is referred to as a percentage restrained differential protection operation characteristic. The data points 620 are the values of the $I_{diff}$ measured over a time window, during which the circuit breaker 231 is opened, i.e. the long cable is electrically disconnected from the grid 202. The data points 620 eventually cross the boundary 610 and enters the operation region 630, in which case an internal fault is determined and a trip signal is issued, using a conventional line differential protection.

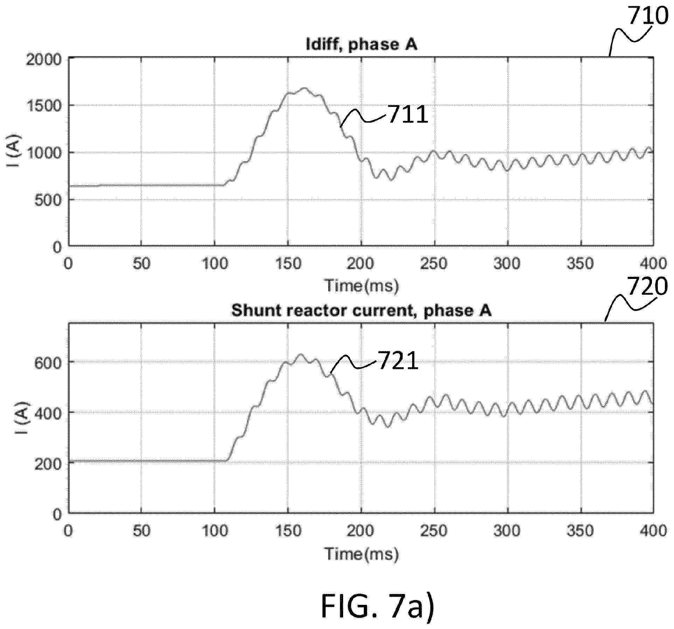

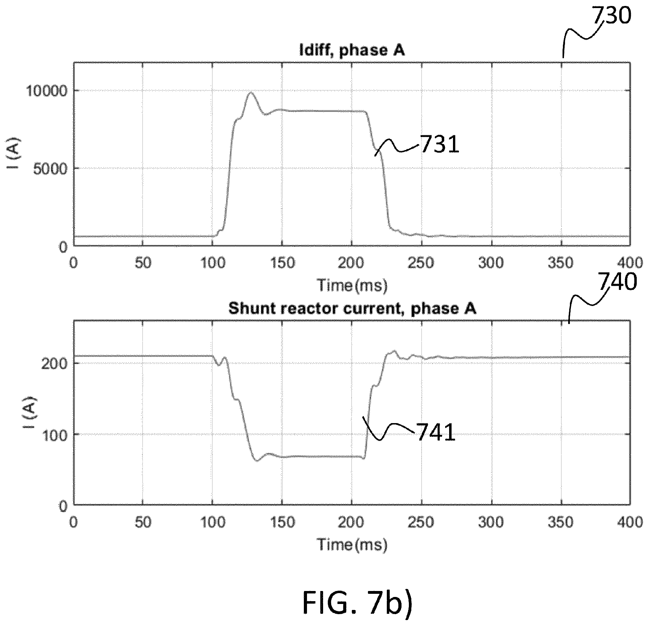

FIG. 7a) and FIG. 7b) illustrate measurements during different operation conditions according to an embodiment of the present disclosure. In particular, a first subplot 710 illustrates root mean squared, rms, values 711 of the differential currents $I_{diff}$ measured for a set measurement period, during which a circuit breaker 231 is opened at *t=100ms,* wherein the rms values 711 of the differential currents $I_{diff}$ is computed as follows:

$$I_{diff_{rms}} = \sqrt{\frac{1}{T}\int_{t1}^{t2} I_{diff}^2(t)dt} \qquad (9)$$

, wherein t2-t1= *T* which denotes a fundamental power period of the considering system (the fundamental power frequency is 50 Hz for Europe and 60 Hz for the United States, thus T= *20ms* and *T=16.67ms,* for Europe and the United States, respectively). A second subplot 720 of FIG. 7a) illustrates root mean squared, rms, values 721 of the third shunt reactor current $I_{sr}$ measured for a set measurement period, during which a circuit breaker 131 is opened at *t=100ms,* wherein the rms values 721 of the third shunt reactor current $I_{sr}$ as follows:

$$I_{sr_{rms}} = \sqrt{\frac{1}{T}\int_{t1}^{t2} I_{sr}^2(t)dt} \qquad (10)$$

. A third subplot 730 illustrates root mean squared, rms, values 731 of the differential currents $I_{diff}$ measured for a set measurement period, during which an internal fault is occurred *t=100ms,* wherein the rms values are computed according to eq.(9). A fourth subplot 740 illustrates root mean squared, rms, values 741 of the third shunt reactor current $I_{sr}$ measured for a set measurement period, during which an internal fault is occurred *t=100ms,* wherein the rms values are computed according to eq.(10). The arrows in the subplots 710, 720, 730, and 740 represents the polarity of the time derivative of each of the parameters 711, 721, 731, and 741, in particular for a short time period after either an internal fault occurs, or a circuit breaker opens. As evident from the first subplot 710 and the second subplot 720, the time derivates of the parameters 711 and 721 are positive, indicated by the arrows pointing diagonally upwards due to an overvoltage at the fourth measurement point 244. However, the time derivative of the differential current 731 in the third subplot 730 is positive whereas the time derivative of the third shunt reactor current $I_{sr}$ 741 in the fourth subplot 740 is negative, indicated by the arrow pointing diagonally downwards due to a voltage drop at the fourth measurement point 244. Thus, in case FIG. 7a) is observed, the abnormal operation is determined. Accordingly, preset setting of the line differential protection system may be adjusted.

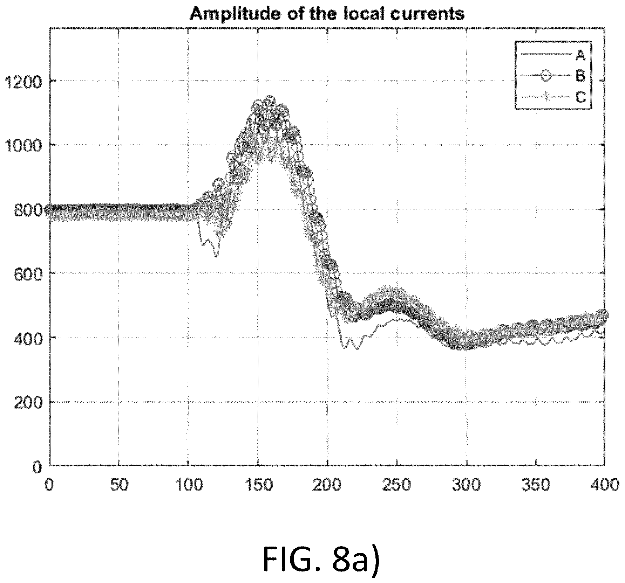

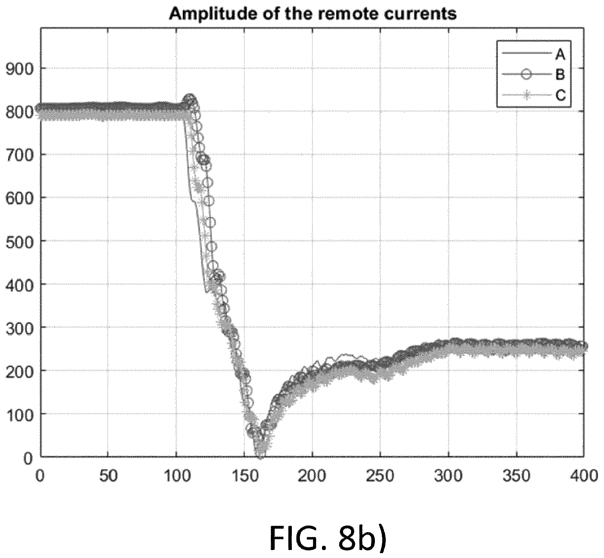

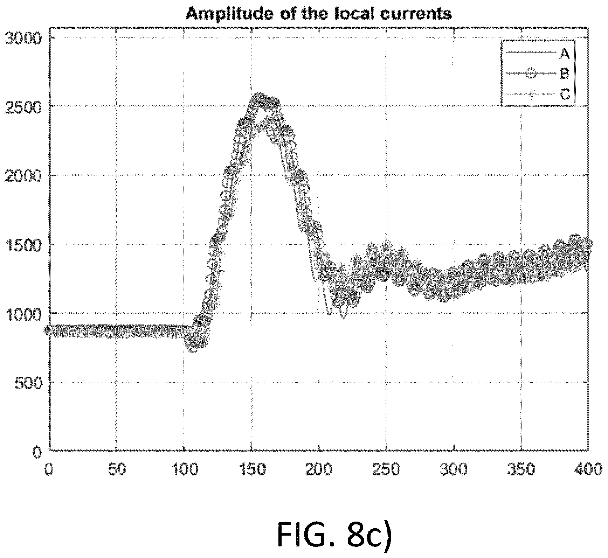

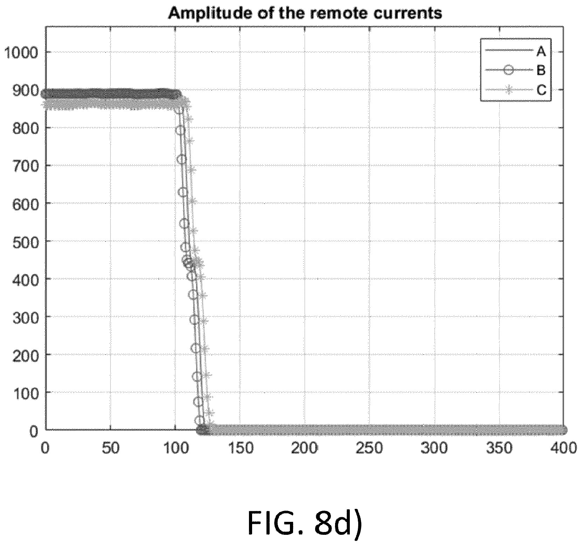

FIG. 8a) to FIG. 8d) illustrate measurement results at various measurement points along the transmission line illustrated in FIG. 2. In particular, FIG. 8a) to FIG. 8d) illustrate the amplitude of the currents of three phases flowing through the first, the second, the third, and the fourth measurement points 241, 242, 243, and 244, respectively. The said measured currents are measured for a time period, during which the circuit breaker 231 is opened at *t=100ms.* As evident from FIG. 8d), the amplitude of the currents of three phases measured at the fourth measurement position 244 converges close to zero shortly after (e.g. approximately *25ms)* the circuit breaker 231 opens. Accordingly, the third criterion 303 may be used to evaluate the current through the fourth measurement point 244, based on which the preset setting may be adjusted according to the embodiment illustrated in FIG. 3.

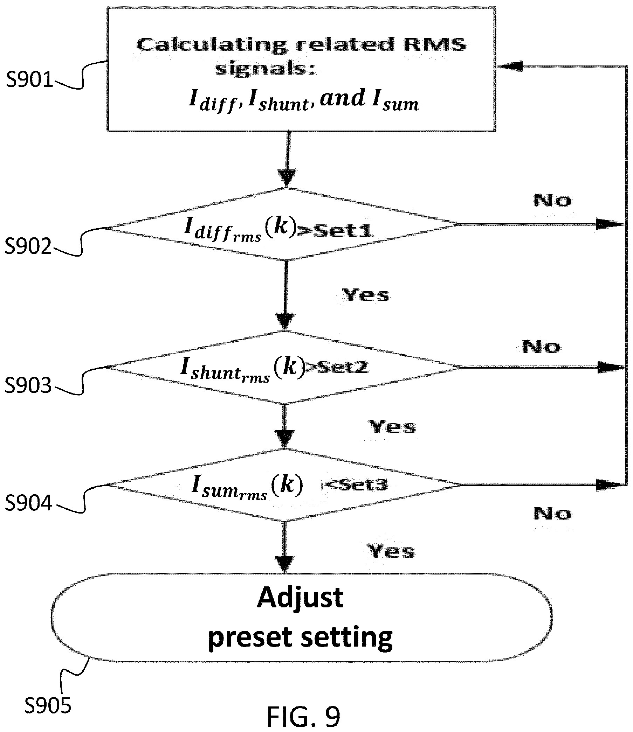

FIG. 9 illustrates a flow chart of the method according to an embodiment of the present disclosure. In particular, the flow chart of FIG. 9 illustrates an alternative method to adjust the preset setting. A first block S901 computes rms values of the $I_{diff}$ and the $I_{shunt}$ according to eq.(9) and eq.(10), respectively. The first block S901 further computes rms values of a current sum, $I_{sum}$, as follows:

$$I_{sum_{rms}}(t) = \sqrt{\frac{1}{T}\int_T I_{sum}^2(t)\ dt} \qquad (11)$$

, wherein the current, $I_{sum}$, is computed as follows:

$$I_{sum}(t) = \left| I_{d_{inst}}(t) + I_{shunt}(t) \right| \qquad (12)$$

, wherein $I_{d_{inst}}$ and the $I_{shunt}$ denote the second capacitive leakage current and the third shunt reactor current, respectively. A second block S902 evaluates whether the sample value of the $I_{diff_{rms}}$ at the $k^{th}$ sample index is bigger than a preset value, set1, and returns to the first block S901 when the evaluation yields false or proceeds to a third block S903 when the evaluation yields true. The third block S903 evaluates whether the sample value of the $I_{shunt_{rms}}$ at the $k^{th}$ index is bigger than a preset value, set2, and returns to the first block S901 when the evaluation yields false or proceeds to a fourth block S904 when the evaluation yields true. The fourth block S904 evaluates whether the sample value of the $I_{sum_{rms}}$ at the $k^{th}$ sample index is smaller than a preset value, set3, and returns to the first block S901 when the evaluation yields false or proceeds to a fifth block S905 when the evaluation yields true. The block S904 adjusts the preset setting.

It is understood by the skilled person that the flow chart illustrated in FIG. 9 is merely an exemplary embodiment illustrating sequential decisions and that the blocks S902, S903, and S904 may form any algorithmic hierarchy, i.e. any one of said blocks S902, S903, and S904 may be performed alone or in any combination of said blocks S902, S903, and S904 in sequence and/or in parallel, in particular using 'AND' and/or 'OR' logical operators. According to an embodiment, the second block S902 and the third block S903 correspond to the second criterion 302 and that the fourth block S904 is a further criterion to be evaluated, before adjusting the preset setting. According to an embodiment, the preset setting is adjusted S905 without evaluating at least one of the bocks S902, S903, or S904.

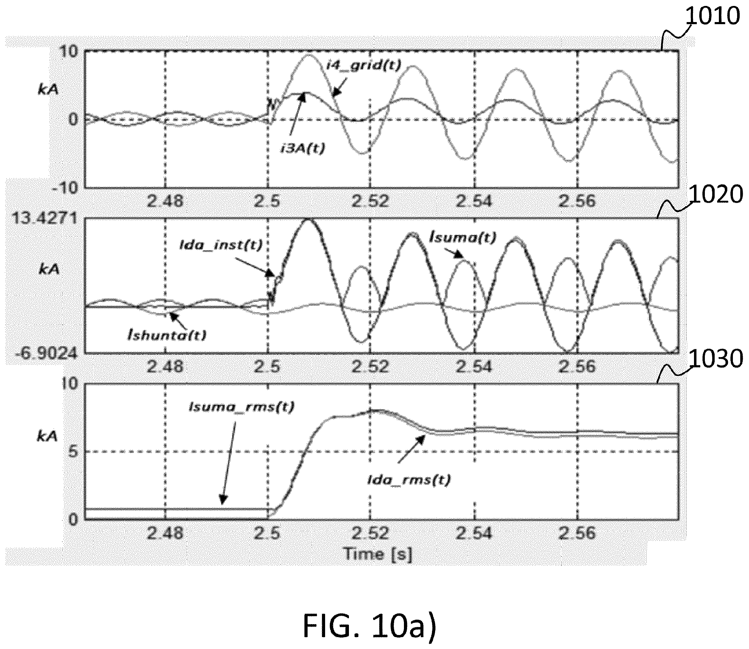

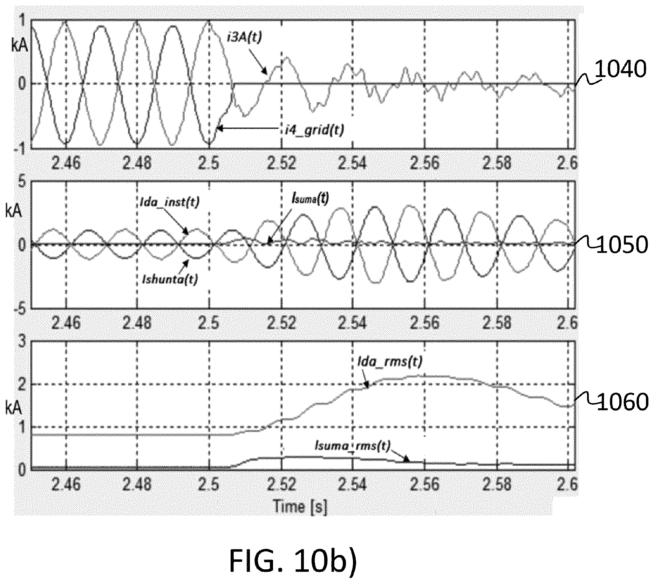

FIG. 10a) and FIG. 10b) illustrate measurements and computed parameters of a single-phase signal during different operation settings.

In particular, FIG. 10a) illustrates a first subplot 1010, a second subplot 1020, and a third subplot 1030. The first subplot 1010 illustrates a phase-A current through the third measurement point 243 and the fourth measurement point 244, obtained in a time window during which a circuit breaker opens. A second subplot 1020 illustrates phase-A $I_{d_{inst}}$, $I_{sr}$ and $I_{sum}$ according to eq.(12) obtained and computed within a time window during which a circuit breaker opens. A third subplot 1030 illustrates phase-A $I_{sum_{rms}}$ according to eq.(11) and rms values of the phase-A $I_{d_{inst}}$, $I_{dinst,rms}$, within a time window, during which a circuit breaker opens. FIG. 10b) illustrates a fourth subplot 1040, a fifth subplot 1050, and a sixth subplot 1060 and each subplot 1040, 1050, and 1060 illustrates the respective currents illustrated in the first subplot 1010, the second subplot 1020, and the third subplot 1030. However, in contrary to the subplots 1010, 1020, and 1030 of FIG. 10a), the subplots 1040, 1050, and 1060 of FIG. 10b) are obtained within a time window during which an internal fault occurs at.

As evident from the third subplot 1030, the amplitude of the $I_{sum_{rms}}$ increases shortly after the circuit breaker 231 opens and approximately follows the current profile of the $I_{dinst,rms}$. In contrary, as illustrated in the sixth subplot 1060, shortly after an internal fault, the amplitude of the $I_{sum_{rms}}$ does not increase in comparison to the $I_{sum_{rms}}$ after the opening of the circuit breaker 231. Thus, the block S904 may be used, the result of which is used to adjust the preset setting. According to an embodiment, the measured differential current, $I_{diff}$, in three phase transmission line is the second capacitive leakage current and flows in the opposite direction as the third shunt reactor current $I_{sr}$ under normal operation, i.e. in the absence of a fault. In contrast, during fault conditions, the measured differential current, $I_{diff}$, is an inductive featured current which flows in the same direction as the third shunt reactor current $I_{sr}$. Such observation allows for the block S904 to be used as a conditional statement to be evaluated, the result of which is used to adjust the preset setting.

According to an embodiment, another criterion comprising rms values of the charging current $I_{charging_{rms}}$ is evaluated as follows:

$$I_{charging_{rms}}(t) > I_{charging,th} \qquad (13)$$

, wherein $I_{charging,th}$ is a threshold current and the $I_{charging_{rms}}$ is computed as follows:

$$I_{charging_{rms}}(t) = \frac{I_{charging_{rms,pre-fault}} \times V_{local_{rms}}}{V_{local_{rms,pre-fault}}} \qquad (13)$$

, wherein $I_{charging_{rms},pre-fault}$, $V_{local_{rms}}$, and $V_{local_{rms,pre-fault}}$ denote a rms of the charging current measured priorto the fault instance, a rms of the local voltage, and a rms value of the local voltage prior to the fault instance. According to an embodiment, when the circuit breaker 231 opens, the measured capacitive charging current is an actual differential current, $I_{diff}$, as there is no internal fault in the line. Thus, the $I_{charging_{rms}}$ increases linearly with the $V_{local_{rms}}$ according to eq.(13). That is, when the condition of eq.(13) is true.

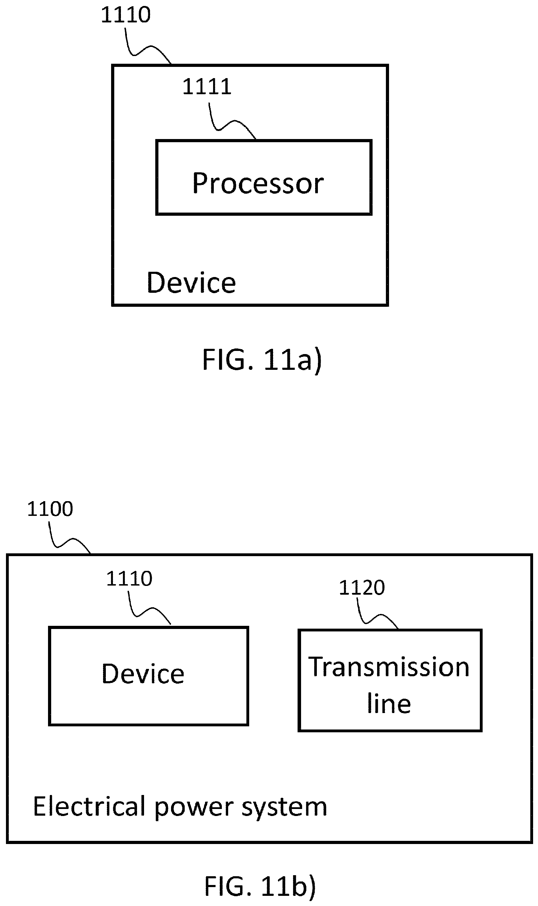

FIG. 11a) and 11b) illustrate a device and an electrical power system according to embodiments of the present disclosure. In particular, FIG. 11a) illustrates a device according to an embodiment of the present disclosure. The device 1110 is a device for controlling a line differential protection system for an electrical power system and the device comprises a processor 111. FIG. 11b) illustrates an electrical power system according to an embodiment of the present disclosure. The electrical power system 1100 comprises a transmission line 1120 being protected by the line differential protection system controlled by the device 1110 comprising a processor 1111 being configured to perform any one of the above-described embodiments.

According to an embodiment, the processor is configured to: determine, based on at least one first parameter, an abnormal operation condition; adjust, based on the determined abnormal operation condition, a preset setting of the line differential protection system; and control, based on the adjusted preset setting, the line differential protection system.

According to an embodiment, the processor is further configured to: determine, based on the adjusted preset setting, a fault in the transmission line; and controlling, based on the determined fault, the line differential protection system. According to an embodiment, the controlling the line differential protection system comprises controlling an operation of the line differential protection system.

According to an embodiment, the device further comprises a first sensor configured to sense the at least one first parameter at a first end of a transmission line of the electrical power system, wherein the sensed at least one first parameter particularly comprises a single-phase current through the first end.

According to an embodiment, the device further comprises a second sensor configured to sense at least one second parameter at a second end of the transmission line, wherein the sensed at least one second parameter is or comprises a single-phase current through the second end, wherein the sensed at least one first parameter comprises a current through a shunt component connected to the transmission line, in particular at the first end of the transmission line; and; and wherein the processor is further configured to: determine, based on the sensed at least one first parameter and the sensed at least one second parameter, a differential current; and determine, based on the determined differential current and the sensed current through the shunt component, the abnormal operation condition.

According to an embodiment, the first sensor and the second sensor are communicatively coupled to each other and/or to the processor.

According to an embodiment, the line differential protection system comprises controlled actuatable devices, including a relay, a current transformer, a voltage transformer, and/or a trip circuit and/or circuit breakers located at respective ends (the first end and the second end) of the transmission line and/or the protected portion of the transmission line. According to an embodiment, the controlling the line differential protection system comprises controlling any combination of the controlled actuatable devices.

According to an embodiment, the processor is configured to determine the abnormal operation condition when the determined differential current and the sensed current through the shunt component increase simultaneously.

According to an embodiment, the sensed at least one first parameter is a voltage at the first end and wherein the processor is configured to determine the abnormal operation condition by comparing the sensed at least one first parameter to a preset value.

According to an embodiment, the sensed at least one first parameter is or comprises a single-phase current through the first end and wherein the processor is configured to determine the abnormal operation condition by comparing the sensed at least one first parameter to a preset value.

According to an embodiment, the processor is configured to adjust the preset setting by increasing a threshold value of the preset setting of the line differential protection system.

In the following, exemplary embodiments of the disclosure will be described. It is noted that some aspects of any one of the described embodiments may also be found in some other embodiments unless otherwise stated or obvious. However, for increased intelligibility, each aspect will only be described in detail when first mentioned and any repeated description of the same aspect will be omitted.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative methods, logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organization.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the novel features and principles disclosed herein, as recited in the claims below.

## Claims

1. A method for controlling a line differential protection system for an electrical power system, the method comprising:

   sensing at least one first parameter at a first end of a transmission line of the electrical power system;
   determining, based on the sensed at least one first parameter, an abnormal operation condition;
   adjusting, based on the determined abnormal operation condition, a preset setting of the line differential protection system; and
   controlling, based on the adjusted preset setting, the line differential protection system.

2. The method of claim 1, further comprising:

   determining, based on the adjusted preset setting, a fault in the transmission line; and
   controlling, based on the determined fault, the line differential protection system.

3. The method of claim 1 or 2, further comprising:

   sensing at least one second parameter at a second end of the transmission line,
   wherein the sensed at least one first parameter is or comprises a single-phase current through the first end and the sensed at least one second parameter is or comprises a single-phase current through the second end;
   determining, based on the sensed at least one first parameter and the sensed at least one second parameter, a differential current;
   sensing a current through a shunt component connected to the transmission line, in particular at the first end of the transmission line; and
   determining, based on the determined differential current and the sensed current through the shunt component, the abnormal operation condition.

4. The method of claim 3, wherein the abnormal operation condition is determined when the determined differential current and the sensed current through the shunt component increase simultaneously.

5. The method of any one of claims 1 to 4, wherein the sensed at least one first parameter is a voltage at the first end and wherein the determining the abnormal operation condition is or comprises comparing the sensed at least one first parameter to a preset value.

6. The method of any one of claims 1 to 5, wherein the sensed at least one first parameter is or comprises a single-phase current through the first end and wherein the determining the abnormal operation condition is or comprises comparing the sensed at least one first parameter to a preset value.

7. The method of any one of claims 1 to 6, wherein the adjusting the preset setting is or comprises increasing a threshold value of the preset setting of the line differential protection system.

8. A device for controlling a line differential protection system for an electrical power system, the device comprising a processor being configured to:

   determine, based on at least one first parameter, an abnormal operation condition;
   adjust, based on the determined abnormal operation condition, a preset setting of the line differential protection system; and

control, based on the adjusted preset setting, the line differential protection system.

9. The device of claim 8, wherein the processor is further configured to:

   determine, based on the adjusted preset setting, a fault in the transmission line; and
   controlling, based on the determined fault, the line differential protection system.

10. The device of claim 8 or 9, further comprising a first sensor configured to sense the at least one first parameter at a first end of a transmission line of the electrical power system, wherein the sensed at least one first parameter particularly comprises a single-phase current through the first end.

11. The device of claim 10, further comprising a second sensor configured to sense at least one second parameter at a second end of the transmission line,

   wherein the sensed at least one second parameter is or comprises a single-phase current through the second end,
   wherein the sensed at least one first parameter comprises a current through a shunt component connected to the transmission line, in particular at the first end of the transmission line; and

   wherein the processor is further configured to:

   determine, based on the sensed at least one first parameter and the sensed at least one second parameter, a differential current; and
   determine, based on the determined differential current and the sensed current through the shunt component, the abnormal operation condition.

12. The device of claim 11, wherein the processor is configured to determine the abnormal operation condition when the determined differential current and the sensed current through the shunt component increase simultaneously.

13. The device of any of claims 10 to 12, wherein the sensed at least one first parameter is a voltage at the first end and wherein the processor is configured to determine the abnormal operation condition by comparing the sensed at least one first parameter to a preset value.

14. The device of any of claims 10 to 13, wherein the sensed at least one first parameter is or comprises a single-phase current through the first end and wherein the processor is configured to determine the abnormal operation condition by comparing the sensed at least one first parameter to a preset value.

15. The device of any of claims 10 to 14, wherein the processor is configured to adjust the preset setting by increasing a threshold value of the preset setting of the line differential protection system.

16. An electrical power system comprising a transmission line and the device of any of claims 8 to 15.

```
                ┌─────────────────────────────────────────┐
                │  sensing at least one first parameter    │
  S101          │  at a first end of a transmission line   │
                │  of the electrical power system          │
                └─────────────────────────────────────────┘
                                    │
                                    ▼
                ┌─────────────────────────────────────────┐
                │  determining, based on the sensed at     │
  S102          │  least one first parameter, an abnormal  │
                │  operation condition                     │
                └─────────────────────────────────────────┘
                                    │
                                    ▼
                ┌─────────────────────────────────────────┐
                │  adjusting, based on the determined      │
  S103          │  abnormal operation condition, a preset  │
                │  setting of the line differential        │
                │  protection system                       │
                └─────────────────────────────────────────┘
                                    │
                                    ▼
                ┌─────────────────────────────────────────┐
  S104          │  controlling, based on the adjusted      │
                │  preset setting, the line differential   │
                │  protection system                       │
                └─────────────────────────────────────────┘
```

FIG. 1

FIG. 2

EP 4 333 228 A1

EP 4 333 228 A1

301 — $V_{ph} > V_{setting}$

302 — Both Idiff & Isr increase

303 — $3*I_{ph} \approx 0$

320 — OR

Adjust preset setting

FIG. 3

FIG. 4

EP 4 333 228 A1

**Amplitude of the Idiff.**

FIG. 5

FIG. 6

EP 4 333 228 A1

FIG. 7a)

FIG. 7b)

EP 4 333 228 A1

**Amplitude of the local currents**

FIG. 8a)

FIG. 8b)

**Amplitude of the local currents**

FIG. 8c)

FIG. 8d)

Calculating related RMS
signals:

$I_{diff}, I_{shunt}, and\ I_{sum}$

S901

S902  $I_{diff_{rms}}(k)$>Set1    No

Yes

S903  $I_{shunt_{rms}}(k)$>Set2    No

Yes

S904  $I_{sum_{rms}}(k)$  <Set3    No

Yes

**Adjust
preset setting**

S905

FIG. 9

FIG. 10a)

EP 4 333 228 A1

FIG. 10b)

EP 4 333 228 A1

1110

1111

Processor

Device

FIG. 11a)

1100

1110

1120

Device

Transmission line

Electrical power system

FIG. 11b)

**EP 4 333 228 A1**

Europäisches
Patentamt

European
Patent Office

Office européen
des brevets

# EUROPEAN SEARCH REPORT

**Application Number**

EP 22 19 2822

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/073407 A1 (COOPER TECHNOLOGIES CO [US]; KOJOVIC LJUBOMIR A [US] ET AL.) 11 June 2009 (2009-06-11) * abstract; figures 2,5 * * paragraphs [0020], [0027] – [0029], [0036] – [0037] * | 1,2, 6–10, 14–16 | INV. H02H1/04 G01R31/08 H02H3/00 H02H3/28 |
| X | WO 2017/129233 A1 (ABB SCHWEIZ AG [CH]) 3 August 2017 (2017-08-03) * abstract; figures 1-4 * | 1,2, 6–10, 14–16 | |
| X | CN 102 868 150 B (CHINA ELECTRIC POWER RES INST; STATE GRID CORP CHINA) 15 April 2015 (2015-04-15) * the whole document * | 1–4, 6–12, 14–16 | |
| X | "Feasibility of adaptive protection and control", IEEE TRANSACTIONS ON POWER DELIVERY, IEEE SERVICE CENTER, NEW YORK, NY, US, vol. 8, no. 3, 1 July 1993 (1993-07-01), pages 975–983, XP011352480, ISSN: 0885-8977, DOI: 10.1109/61.252625 * the whole document * | 1,2,5, 7–9,13, 15,16 | TECHNICAL FIELDS SEARCHED (IPC) H02H G01R |
| X | EP 2 012 402 A2 (AREVA T & D UK LTD [GB]) 7 January 2009 (2009-01-07) * figures 1,6,7 * * paragraphs [0020] – [0041]; claims 1-3 * | 1,2, 6–10, 14–16 | |

-/--

The present search report has been drawn up for all claims

| Place of search | Date of completion of the search | Examiner |
|---|---|---|
| Munich | 10 February 2023 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

**EP 22 19 2822**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | XU ZHIHAN ET AL: "87L application on long transmission line with series capacitor banks and shunt reactors", 2014 67TH ANNUAL CONFERENCE FOR PROTECTIVE RELAY ENGINEERS, IEEE, 31 March 2014 (2014-03-31), pages 627-663, XP032590527, DOI: 10.1109/CPRE.2014.6799034 [retrieved on 2014-04-15] * the whole document * | 1-16 | |

TECHNICAL FIELDS
SEARCHED     (IPC)

The present search report has been drawn up for all claims

| Place of search | Date of completion of the search | Examiner |
|---|---|---|
| Munich | 10 February 2023 | Palukova, Mila |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

**ANNEX TO THE EUROPEAN SEARCH REPORT
ON EUROPEAN PATENT APPLICATION NO.**

EP 22 19 2822

10-02-2023

| Patent document cited in search report | | Publication date | Patent family member(s) | | Publication date |
|---|---|---|---|---|---|
| WO 2009073407 | A1 | 11-06-2009 | BR PI0820011 A2 | | 19-05-2015 |
| | | | CA 2707481 A1 | | 11-06-2009 |
| | | | EP 2223404 A1 | | 01-09-2010 |
| | | | ES 2542877 T3 | | 12-08-2015 |
| | | | TW 200934027 A | | 01-08-2009 |
| | | | US 2009147412 A1 | | 11-06-2009 |
| | | | WO 2009073407 A1 | | 11-06-2009 |
| WO 2017129233 | A1 | 03-08-2017 | CN 108475913 A | | 31-08-2018 |
| | | | EP 3408910 A1 | | 05-12-2018 |
| | | | US 2018358802 A1 | | 13-12-2018 |
| | | | WO 2017129233 A1 | | 03-08-2017 |
| CN 102868150 | B | 15-04-2015 | NONE | | |
| EP 2012402 | A2 | 07-01-2009 | CA 2636977 A1 | | 06-01-2009 |
| | | | CN 101340078 A | | 07-01-2009 |
| | | | EP 2012402 A2 | | 07-01-2009 |
| | | | US 2009009181 A1 | | 08-01-2009 |

EPO FORM P0459